# EUROPEAN PATENT APPLICATION

(11) **EP 0 981 167 A2**
(43) Date of publication of application: **23.02.2000**
(21) Application number: 99306553.1
(22) Date of filing: 19.08.1999
(51) Int. Cl.: H01L 31/048, H01L 31/052

(54) **Integrated photovoltaic composite panel**

(30) Priority: 19.08.1998 GB 9817967
(71) Applicant: British Steel Limited, London NW1 5JD (GB)
(72) Inventor: John, Vernon, Caerphilly, Mid Glamorgan, CF83 1EJ (GB); Uniacke, Henry George Martin, Roath, Cardiff (GB); Marshall, Richard Hamnett, Penylan, Cardiff (GB); Spratt, Mark Robert, Spott, Cardiff (GB)
(74) Representative: Fry, Alan Valentine

(57) **Abstract**

The invention provides an integrated PV composite panel and methods for providing the same, the panel comprising a core structure (1) and an outer skin (6), the core structure including an insulated corrugated or castellated metallic-coated steel sheet (2), and the outer skin comprising a layer of amorphous or crystalline PV cells (11), a channel (10) being formed between the core structure and the outer skin to provide ventilation and/or cooling for the PV cells.

## Description

The invention relates to apparatus for converting solar energy into electricity. More especially, but not exclusively, the invention relates to integrated photovoltaic composite panels suitable for use in buildings and cladding therefor.

The increasing global population, coupled with rising living standards, is causing a rapid depletion of non-renewable energy sources such as oil, gas and coal. Furthermore, carbon dioxide emissions that result from burning of these fuels are believed to be major contributors to global warming. Consequently, there is an acute need to reduce energy consumption to more sustainable levels.

More energy is used for heating and cooling buildings than for any other purpose. Typically this accounts for more than 35% of the primary energy usage throughout Europe. Commercial buildings have higher operational energy requirements than any other major building type, and are therefore particularly significant in terms of opportunities for energy reduction. As a result, legislation has been, and is continuing to be, put in place throughout Europe to minimise energy use in commercial buildings. This legislation reflects governmental desires to improve the sustainability of energy usage, to avoid pollution, and to reduce production of carbon dioxide and other so-called green-house gases associated with the burning of fossil fuels.

Within governments, the scientific community, and environmental organisations, there is a growing recognition of the valuable role solar power can play in reducing carbon dioxide levels. Many technologies have been developed to harness the power of the sun. Solar photovoltaics (PV) offers the versatility of an electrical output. PV systems are already generating power for many purposes, and in many parts of the world on an economic basis. As PV costs have been driven down and the demand for clean energy has escalated, a potentially vast market is beginning to emerge in the developed world for a multiplicity of PV systems connected to provide mains electricity in a grid system. Integrated aesthetically into the facades of office or commercial buildings, or mounted on the roof of domestic houses, grid-connected PV systems offer the opportunity to generate significant quantities of electricity.

A building-integrated PV system comprises a solar array and an inverter to convert the direct current (DC) output of PV cells into alternating current (AC) electricity. Such a system can also include a metering system to monitor the balance between the quantity of electricity drawn from the grid and any surplus supplied to the grid by the PV system during the day.

A typical residential roof top system comprises a 3kW solar array of PV cells, which is retrofitted *over* an existing roof structure. For new buildings, improved economies can be obtained by *integrating* PV cells directly into the roof structure, so that the solar array serves a dual function, not only generating electricity, but also providing weather protection. For office or commercial buildings the electricity generated can be used, for example, to power computers, air handling and lighting equipment.

The method of cladding used for buildings is, *inter alia,* dependent on a balance between the cost of a conventional cladding system and an equivalent PV system. The economic viability of PV cladding panels is dependent on the kWh cost of generated electricity attributed to the PV cladding costs in excess of conventional cladding. Current PV cladding, which can be anything up to four times the cost of conventional cladding, cannot compete with grid electricity.

The two main cell technologies used in the manufacture of PV panels are crystalline and amorphous.

Crystalline PV cells are made from large crystals that are sliced into wafers. Their assembly into panels has conventionally required a glass structure and a metal surrounding frame. A typical composition comprises glass/PV/encapsulant/polymer or glass/PV/encapsulant/glass. In contrast, amorphous cells are able to be deposited on a flexible substrate which permits a less rigid structure.

An important consideration of crystalline-based systems is the provision of local cooling to the PV cells when in use; this is because the energy conversion efficiency of crystalline PV cells decreases with increasing temperature. Thus, the relatively high cost and weight of a PV cell support structure, the high cost of glass compared with steel, and the assembly and connection problems associated with small and brittle cells contribute to an overall uneconomic cost of current PV cladding panel systems.

It is an object of the present invention to utilise steel cladding and thin film technology to incorporate PV cells into steel clad roofs and facades to produce a composite multi-purpose product which is economical and which provides a feasible and realistic alternative to traditional energy sources while simultaneously offering an outer building skin, passive ventilation and ducted heat for pre-heating air or water.

Accordingly, in one aspect the invention provides an integrated PV composite panel comprising a core structure and an outer skin, the core structure including an insulated corrugated or castellated metallic-coated steel sheet, and the outer skin comprising a layer of amorphous or crystalline PV cells, a channel being formed between the core structure and the outer skin to provide ventilation and/or cooling for the PV cells.

In another aspect, the invention provides an integrated photovoltaic composite panel comprising a core structure and an outer skin, the core structure comprising:-
(i) an inner organic-coated steel layer forming the inside surface of the composite panel;
(ii) an insulation material chemically bonded to the organic-coated steel layer; and,
(iii) a corrugated or castellated metallic-coated steel sheet chemically bonded to the insulation material;
   and the outer skin comprising:-
(iv) a galvanised or organic-coated steel sheet;
(v) a layer of amorphous or crystalline PV cells adhesively bonded to the outer sheet;
(vi) a layer which functions as a PV encapsulant and/or an adhesive to an outer protective layer; and,
(vii) an outer protective layer;
a channel being formed between layers (iii) and (iv) to provide ventilation and/or cooling for the PV cells.

Typically, the panel may be used to passively cool and/or heat a building into which it is incorporated.

The integrated photovoltaic composite panel may be designed to meet the structural properties required for roof and wall cladding, for example, to resist snow and wind loadings to BS6399:Part 3:1988 and BS CP3:Chapter V:Part 2:1972 respectively. The design rules for calculating the structural performance of profiled panels are specified in BS5950:Part 6:1995.

The insulation material chemically bonded to the inner surface of the organic-coated steel layer of the core structure may be selected from a variety of materials including blown polyurethane foam, mineral or spun-rock fibre, and polystyrene.

The insulation material may be bonded to the organic-coated steel layers of the core structure using an adhesive.

The steel sheets of both the core structure and the outer skin may be galvanised and the ventilation and cooling channel(s) defined therebetween may be of any shape but typically may be characterised as sinusoidal, trapezoidal (or box), and ribbed-trapezoidal. Whilst in principle panels in accordance with the invention can be site-assembled or pre-fabricated, a pre-fabricated system offers the most viable and consistent product in terms of effective ventilation and subsequent PV cell cooling efficiency. This is because the inner core structure needs to be bonded firmly to the outer skin for best results.

The lower section of the composite structure, which incorporates the ventilation and cooling channel(s), may be engineered to allow air transfer from the interior of a building via ventilation slots. These may be visible or may be connected to the structure via ducting. The natural ventilation through the channels may be driven by a "chimney stack" effect whereby denser, relatively cool air propels warm air up through the channels.

The invention provides a number of advantages. The ventilation and/or cooling channels carry excess heat upwards as the hot air rises. In winter, the air can thus be recirculated into the building to reduce heating requirements. In the summer, the heat may be released at the top of the cladding and, in conjunction with the insulating layer at the back of the cladding, this prevents a building overheating. The air drawn in at the base of the cladding to replace that lost can come from inside the building and create passive ventilation. Therefore, the invention provides an electricity supply, a structural element as an outer building skin, passive ventilation, and ducted heat that may be used to pre-heat air or water.

The core structure may be manufactured in a continuous process using polyurethane foam for the insulation layer. Such a process may utilise a polyol resin, surfactant and fire retardant additives combined with a catalyst and blowing agent. The advantages of a continuous process include speed of assembly and easy shape accommodation. The process itself involves the application of the formulation of resin, surfactant etc. to the inner skin of the structure; through accurate control of the process the foam expands within a pre-determined space to effect the final design -both the inner steel skin and the corrugated or castellated metallic-coated steel sheet of the structure are fed into the processing line at the same time.

The core structure may be bonded to the metallic or organic-coated steel surface of the outer structure using an adhesive.

In a further aspect, the invention provides an integrated photovoltaic composite panel comprising a core structure and an outer skin, the core structure comprising:-
(i) an inner organic-coated steel layer forming the inside surface of the composite panel;
(ii) an insulation material chemically bonded to the organic-coated steel layer; and,
(iii) a corrugated or castellated metallic-coated steel sheet chemically bonded to the insulation material;
   and the outer skin comprising:-
(iv) a metallic-coated or organic-coated steel sheet;
(v) a layer of crystalline PV cells bonded to the sheet; and,
(vi) an outer protective laminate;
a channel being formed between layers (iii) and (iv) to provide ventilation and/or cooling for the PV cells.

Typically, the panel may be used to passively cool and/or heat a building into which it is incorporated.

When the outer skin structure is to be composed of crystalline cells, it is preferably manufactured using a flat-bed laminating system, which incorporates adhesive bonding under temperature and vacuum.

Preferably, ethyl vinyl acetate (EVA) is used as the adhesive which bonds the PV cells to the steel-based layer (iv) and the outer protective laminate (vi). EVA is also an encapsulant which fills the air gaps between the cells during the laminating process.

Typically, the outer protective laminate is a flexible film. The outer protective film may be a polymer-based laminate, an organic coating or glass panel. Fluorocarbon-based polymer films are preferable because they offer relatively high resistance to degradation in use. However, other polymer films such as polyethylene or polyester-based films may be employed.

In a still further aspect, the invention provides an integrated photovoltaic composite panel comprising a core structure and an outer skin, the core structure comprising:-
(i) an inner organic-coated steel layer forming the inside surface of the composite panel;
(ii) an insulation material chemically bonded to the organic-coated steel layer; and,
(iii) a corrugated or castellated metallic-coated steel sheet chemically bonded to the insulation material;
   and the outer skin comprising the following layers:-
(iv) a metallic-coated or organic-coated steel sheet;
(v) an adhesive layer; and,
(vi) a layer of encapsulated flexible amorphous thin-film PV;
a channel being formed between layers (iii) and (iv) to provide ventilation and/or cooling for the PV cells.

Typically, the panel may be used to passively cool and/or heat a building into which it is incorporated.

Amorphous encapsulation may entail encapsulation of the PV cells prior to attachment to the surface of the steel, or after the cells are placed directly onto the steel.

The process for the manufacture of encapsulated amorphous thin-film PV is well known and described in the literature.

The encapsulated amorphous thin-film PV may be adhesively bonded to the metallic- or organic-coated steel sheet using one of a number of known adhesives such as epoxy, olyester, vinyls or polyurethanes.

In yet another aspect, the invention provides a method for converting solar energy into electricity, comprising the steps of:-
(a) cladding a roof or wall of a building with integrated PV composite panels of the present invention;
(b) electrically linking the panels together; and,
(c) converting a DC output of the PV composite panels on exposure to light into a usable form.

Preferably, the method further includes the installation of an inverter to convert the DC output of the PV cells into AC electricity.

In yet another aspect, the invention provides a method for passively heating and/or cooling a building, comprising the steps of:-
(a) cladding a roof or wall of a building with integrated PV composite panels of the present invention; and either:-
(b) allowing the ventilation and/or cooling channels to carry excess heat upwards as hot air rises so that warm air can be recirculated into the building to reduce heating requirements; or
(c) releasing heat at the top of the cladding which, in conjunction with the insulating layer at the back of the cladding, prevents a building overheating whilst drawing warm air in at the base of the cladding from inside the building to create passive ventilation.

In still a further aspect, the invention provides a roof or wall of a building comprising the integrated PV composite panel of the invention as defined herein.

Various embodiments of the invention will now be described by way of example only, with reference to the following diagrammatic drawings in which:-
Figure 1 is an isometric view of a composite panel structure with flexible amorphous thin-film PV according to one aspect of the invention;
Figure 2 shows a schematic illustration of how two PV cladding panels may be joined;
Figure 3(a) is a front cutaway view with perspective of a composite panel with ventilation channels between the interior and exterior of the panel;
Figure 3(b) is a top plan view of Figure 3(a);
Figure 3(c) is a side view along AA' of the composite panel illustrated in Figure 3(a).
Figure 4 shows how the layers comprising the outer skin structure are positioned within a flat-bed laminator;
Figure 5 shows a schematic illustration of a conventional flat-bed laminator; and,
Figure 6 shows an alternative method of manufacture of the outer structure of the composite panel in the form of a continuous lamination facility.

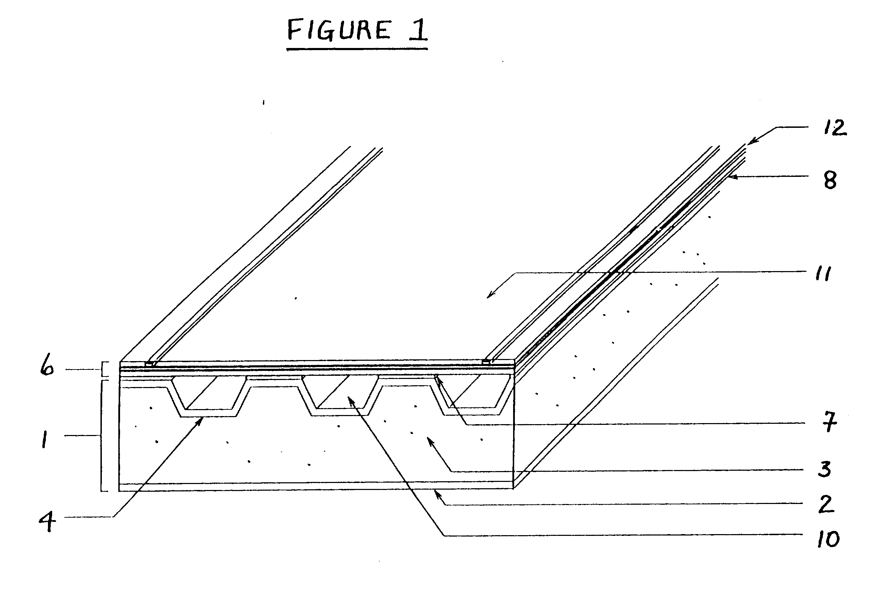

A section of an amorphous thin-film PV building cladding panel according to the invention is shown in Figure 1. The panel has a core structure 1 composed of layers including an inner organic-coated steel layer 2 forming the inside surface of the structure, an insulation material 3 chemically bonded to the organic-coated steel layer, and a corrugated or castellated galvanised steel sheet 4 chemically bonded to the insulation material, the shaped profile of which can be seen in Figure 1. The outer skin 6 of the composite panel is shown in detail in Figure 1. A metallic- or organic-coated steel sheet 8 covers the corrugated or castellated steel sheet of the core structure via an adhesive layer 7, thereby creating cooling and ventilating channels 10. An adhesive layer (not shown) fixes a PV cell layer 11 under a layer of transparent encapsulant 12.

The top steel sheet 8 is encapsulated preferably in a continuous process to incorporate a thin-film of commercially available polymer backed PV material. Thus, a whole polymer-coated (for example polyester or PVC) steel coil is fed through a sequence of processes that can be summarised as including the following steps:-
(a) adhering the PV cells to the steel (using for example, a urethane, polyester or epoxy resin solvent-based, heat cured and roller laminated);
(b) applying a protective encapsulant.

The protective encapsulant can involve a liquid or solid adhesive which is heated to commence cure and over-laminated with a protective layer (for example, fluropolymer, acrylic film or polyester). Examples of a solid adhesive include hot melts such as EVA) these can come with superstrate protective coating already attached). Liquid systems include urethanes and polyesters. Manufacturing techniques might include the use of a vacuum to remove volatiles and air bubbles, pressure from rollers and heat from radiating plates or infra-red lamps.

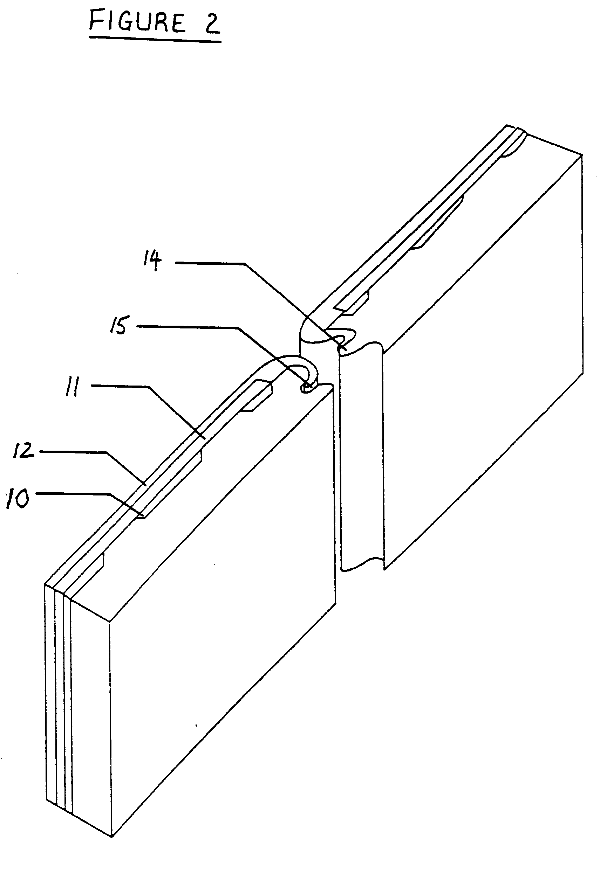

Figure 2 illustrates one possible connection between adjacent PV panels to provide a full weather seal. One side of one panel is provided with a lip 14 which fits snugly into a groove 15 to *inter alia,* prevent moisture from the outside of the building seeping through the cladding.

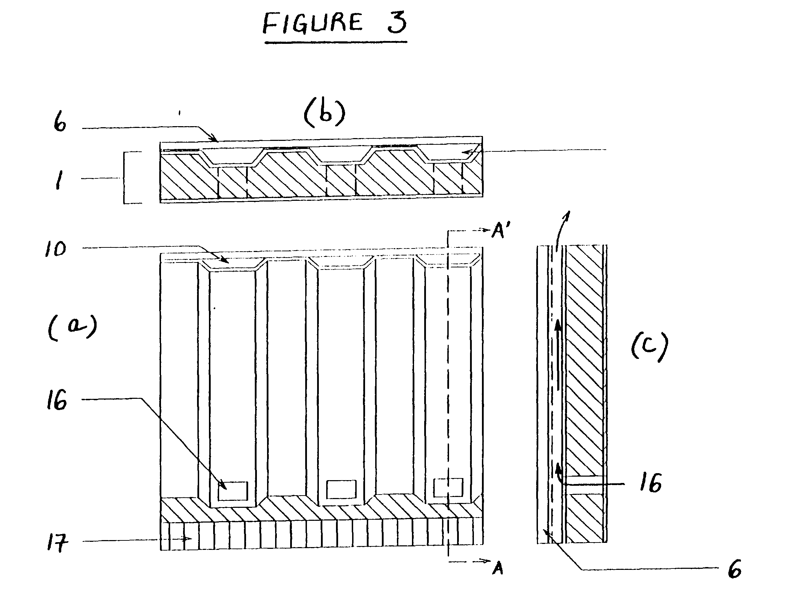

An example of the ventilation engineering possible is shown in Figures 3(a), (b) and (c). As will be seen from these figures, the lower section of a composite panel is engineered to allow air transfer from a building interior via air transfer ventilation slots 16. These may be visible or may be connected to the panel via hidden ducting depending on the architecture required. An insulation layer 17 is positioned between an inner wall surface and the cooling channels 10 and ventilation slots 16. The natural ventilation through the channels is driven by a "chimney stack" effect whereby denser, cool air forces warm air up through the channels.

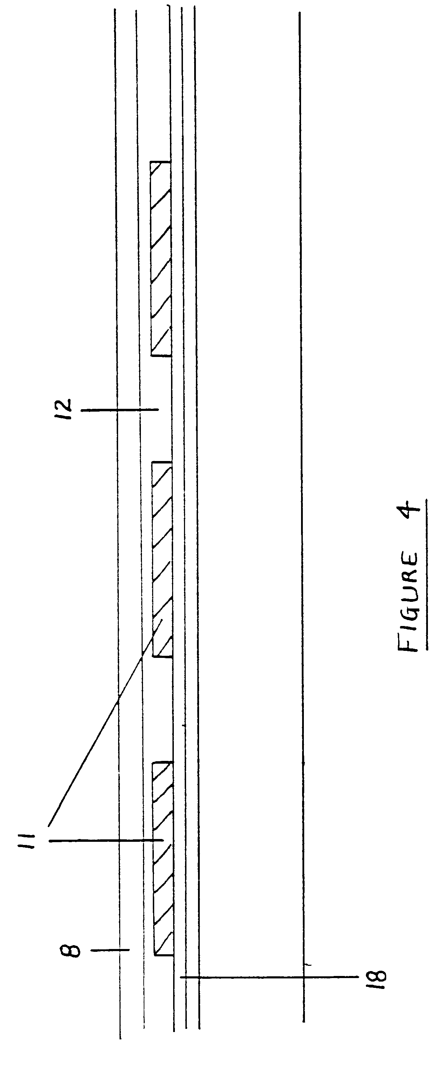

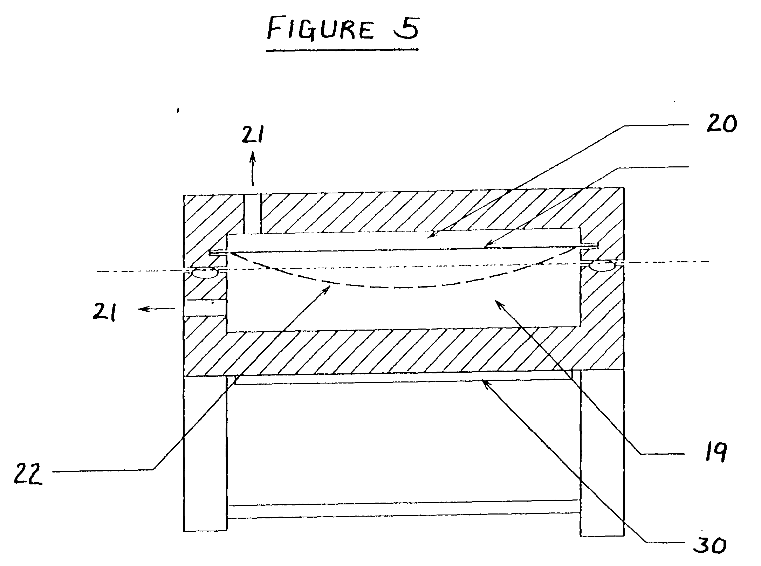

When the outer skin structure is composed of crystalline cells, the structure is best manufactured using flat bed laminating. Flat bed laminating is an established method and is briefly described as follows:- The layers comprising the outer skin structure are positioned within a flat bed laminator as shown in Figure 4. A layer of non-woven glass fibre 18 acts as an evacuation layer, providing an escape route for trapped air and volatiles during the manufacturing process. The procedure is carried out in a flat-bed laminator, schematically illustrated in Figure 5. The laminator has chambers 19, 20 heated to 100°C by heater plates 30 and then evacuated through vacuum pump outlets 21 in order to melt the adhesive layer of the outer skin of the panel and allow it to flow around and encapsulate the cells. The vacuum is maintained for 8-10 minutes before the vacuum in the top chamber 20 is released. This causes a rubber sheet 22 to be pulled down over the laminate under one atmosphere of pressure, squeezing out any trapped air. The heaters are then set to the cure temperature of the adhesive layer (120-150°C) and maintained for 10 to 15 minutes. After this time the heaters are switched off and the vacuum in the bottom chamber released.

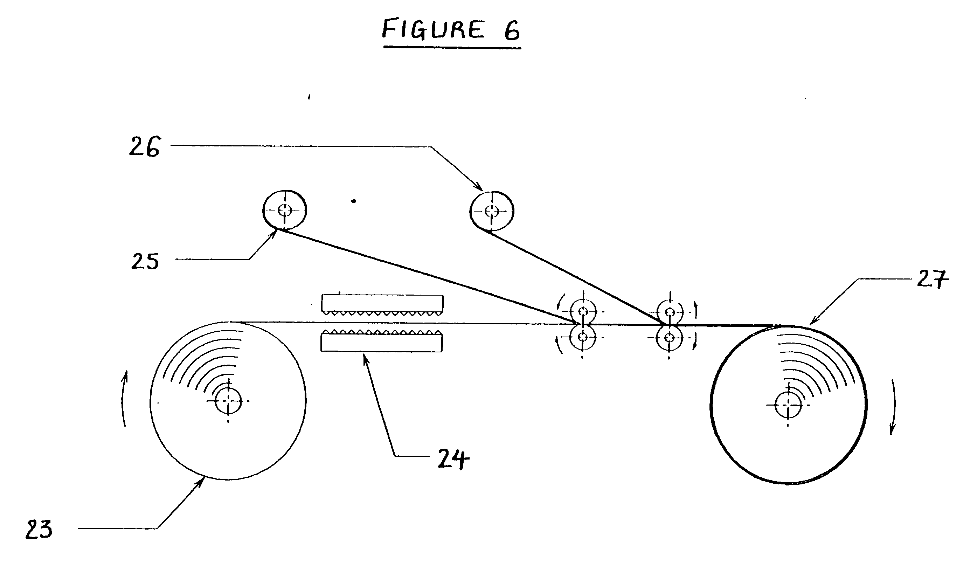

Figure 6 illustrates an example of a continuous lamination facility for the production of the outer structure of the composite panel. Steel from a steel coil 23 is passed between heater plates 24. Thereafter a layer of flexible amorphous PV cells 25 are applied to the steel by rollers, followed by a layer of transparent encapsulant 26. Fully laminated steel coil is collected at the end of the facility 27.

A profiled sheet can also be laminated using the technique. In this case the crystalline cells are laid within the troughs of the profiled sheet.

It will be appreciated that the foregoing is merely exemplary of various embodiments of the invention and that variations can readily be made thereto without departing from the scope of the invention.

## Claims

1. An integrated PV composite panel comprising a core structure and an outer skin, the core structure including an insulated corrugated or castellated metallic-coated steel sheet, and the outer skin comprising a layer of amorphous or crystalline PV cells, a channel being formed between the core structure and the outer skin to provide ventilation and/or cooling for the PV cells.

2. An integrated photovoltaic composite panel comprising a core structure and an outer skin, the core structure comprising:-
(i) an inner organic-coated steel layer forming the inside surface of the composite panel;
(ii) an insulation material chemically bonded to the organic-coated steel layer; and,
(iii) a corrugated or castellated metallic-coated steel sheet chemically bonded to the insulation material;
and the outer skin comprising:-
(iv) a galvanised or organic-coated steel sheet;
(v) a layer of amorphous or crystalline PV cells adhesively bonded to the outer sheet;
(vi) a layer which functions as a PV encapsulant and/or an adhesive to an outer protective layer; and,
(vii) an outer protective layer;
a channel being formed between layers (iii) and (iv) to provide ventilation and/or cooling for the PV cells.

3. An integrated photovoltaic composite panel as claimed in claim 2 wherein the insulation material chemically bonded to the inner surface of the organic-coated steel layer of the core structure is selected from brown polyurethane foam, mineral or spun-rock fibre, and polystyrene.

4. An integrated photovoltaic composite panel as claimed in claim 2 or claim 3 wherein the insulation material is bonded to the organic-coated steel layers of the core structure using an adhesive.

5. An integrated photovoltaic composite panel as claimed in any one of claims 2 to 4 wherein the steel sheets of both the core structure and the outer skin are galvanised.

6. An integrated photovoltaic composite panel as claimed in any one of claims 2 to 5 wherein the ventilation and/or cooling channel(s) defined between the steel sheets are sinusoidal, trapezoidal (or box), or ribbed-trapezoidal.

7. An integrated photovoltaic composite panel as claimed in any one of claims 2 to 6 wherein the panels are site-assembled or pre-fabricated.

8. An integrated photovoltaic composite panel as claimed in claim 7 wherein the panels are pre-fabricated.

9. An integrated photovoltaic composite panel as claimed in any one of claims 2 to 8 wherein the lower section of the composite structure, which incorporates the ventilation and cooling channel(s), is engineered to allow air transfer from the interior of a building via ventilation slots.

10. An integrated photovoltaic composite panel as claimed in claim 9 wherein the ventilation slots are visible or are connected to the structure via ducting.

11. An integrated photovoltaic composite panel as claimed in any one of claims 2 to 10 wherein the core structure is manufactured in a continuous process using polyurethane foam for the insulation layer.

12. An integrated photovoltaic composite panel as claimed in claim 11 wherein the continuous process uses a polyol resin, surfactant and fire retardant additives combined with a catalyst and blowing agent.

13. An integrated photovoltaic composite panel as claimed in any one of claims 2 to 12 wherein the core structure is bonded to the metallic or organic-coated steel surface of the outer structure using an adhesive.

14. An integrated photovoltaic composite panel comprising a core structure and an outer skin, the core structure comprising:-
(i) an inner organic-coated steel layer forming the inside surface of the composite panel;
(ii) an insulation material chemically bonded to the organic-coated steel layer; and,
(iii) a corrugated or castellated metallic-coated steel sheet chemically bonded to the insulation material;
and the outer skin comprising:-
(iv) a metallic-coated or organic-coated steel sheet;
(v) a layer of crystalline PV cells bonded to the sheet; and,
(vi) an outer protective laminate;
a channel being formed between layers (iii) and (iv) to provide ventilation and/or cooling for the PV cells.

15. An integrated photovoltaic composite panel as claimed in claim 14 wherein the outer skin structure is composed of crystalline cells and is manufactured using a flat-bed laminating system which incorporates adhesive bonding under temperature and vacuum.

16. An integrated photovoltaic composite panel as claimed in claim 14 or claim 15 wherein ethyl vinyl acetate (EVA) is the adhesive which bonds the PV cells to the steel-based layer (iv) and the outer protective laminate (vi).

17. An integrated photovoltaic composite panel as claimed in any one of claims 14 to 16 wherein the adhesive is also an encapsulent which fills the air gaps between the cells during the laminating process.

18. An integrated photovoltaic composite panel as claimed in any one of claims 14 to 17 wherein the outer protective laminate is a flexible film.

19. An integrated photovoltaic composite panel as claimed in claim 18 wherein the outer protective laminate is a polymer-based laminate, an organic coating or glass panel.

20. An integrated photovoltaic composite panel as claimed in claim 18 or claim 19 wherein the outer protective laminate is a Fluorocarbon-, a polyethylene- or polyester-based film.

21. An integrated photovoltaic composite panel comprising a core structure and an outer skin, the core structure comprising:-
(i) an inner organic-coated steel layer forming the inside surface of the composite panel;
(ii) an insulation material chemically bonded to the organic-coated steel layer; and,
(iii) a corrugated or castellated metallic-coated steel sheet chemically bonded to the insulation material;
and the outer skin comprising the following layers:-
(iv) a metallic-coated or organic-coated steel sheet;
(v) an adhesive layer; and,
(vi) a layer of encapsulated flexible amorphous thin-film PV;
a channel being formed between layers (iii) and (iv) to provide ventilation and/or cooling for the PV cells.

22. An integrated photovoltaic composite panel as claimed in claim 21 wherein amorphous encapsulation entails encapsulation of the PV cells prior to attachment to the surface of the steel, or after the cells are placed directly onto the steel.

23. An integrated photovoltaic composite panel as claimed in claim 21 or claim 22 wherein the encapsulated amorphous thin-film PV is adhesively bonded to the metallic- or organic-coated steel sheet using an adhesives such as epoxy, olyester, vinyls or polyurethanes.

24. A method for converting solar energy into electricity, comprising the steps of:-
(a) cladding a roof or wall of a building with integrated PV composite panels as defined in any one of claims 1 to 26;
(b) electrically linking the panels together; and,
(c) converting a DC output of the PV composite panels on exposure to light into a usable form.

25. A method as claimed in claim 24 further including the installation of an inverter to convert the DC output of the PV cells into AC electricity.

26. A method for passively heating and/or cooling a building, comprising the steps of:-
(a) cladding a roof or wall of a building with integrated PV composite panels of the present invention; and either:-
(b) allowing the ventilation and/or cooling channels to carry excess heat upwards as hot air rises so that warm air can be recirculated into the building to reduce heating requirements; or
(c) releasing heat at the top of the cladding which, in conjunction with the insulating layer at the back of the cladding, prevents a building overheating whilst drawing warm air in at the base of the cladding from inside the building to create passive ventilation.

27. A roof or wall of a building comprising the integrated PV composite panel of the invention as defined in any one of claims 1 to 23.
